# EUROPEAN PATENT APPLICATION

(11) **EP 0 598 577 A1**
(43) Date of publication of application: **25.05.1994**
(21) Application number: 93309100.1
(22) Date of filing: 15.11.1993
(51) Int. Cl.: H03F 9/02

(54) **Improvement to non-saturating magnetic amplifier controller**

(30) Priority: 17.11.1992 US 977363
(71) Applicant: HUGHES MISSILE SYSTEMS COMPANY, Los Angeles, California 90080-0028 (US); CALIFORNIA INSTITUTE OF TECHNOLOGY, Pasadena California 91125 (US)
(72) Inventor: Vollin, Jeffrey L., West Hills, California 91304 (US); Tan, Dong, Pasadena, California 91106 (US)
(74) Representative: Colgan, Stephen James

(57) **Abstract**

A magnetic amplifier including a magnetic core having a primary leg (11), a secondary leg (12), and first and second control legs (13, 14) each spaced at substantially the same distance from the primary leg. A primary winding (21) is disposed about the primary leg, a secondary winding (22) is disposed about the secondary leg, and first and second serially connected windings (13, 14) are respectively disposed about the first and second control legs for inducing a control flux in the first and second control legs which are configured to prevent control flux from flowing in the primary and secondary legs.

## Description

### BACKGROUND OF THE INVENTION

The subject invention relates generally to magnetic amplifiers, and more particularly to an improved non-saturating magnetic amplifier.

Commonly assigned U.S. Patent 4,821,428 discloses a plurality of non-saturating magnetic amplifier structures each of which generally includes a primary winding, a secondary winding, and one or two control windings around associated legs of a magnetic core. Control current in the control winding or windings varies the permeability of the core material, which provides for control over the primary to secondary conversion ratio.

One of the structures disclosed in U.S. Patent 4,821,428 is a three leg device which utilizes parallel side by side magnetic cores wherein each core includes three parallel legs in a line, and wherein one pair of the side-by-side legs comprise control legs having respective control windings which are serially connected. A consideration with the three leg device is the complexity of its equivalent circuit, which requires a more complex and expensive control circuit for controlling the device. Moreover, additional components may be required to compensate for the complexity of the three leg device, which would reduce the efficiency of a circuit utilizing such three leg device. A further consideration with the three leg device is the presence of DC flux in the primary leg which increases the AC power loss in the core of the device.

The other structures disclosed in U.S. Patent 4,821,428 are four leg devices which utilize a single four leg magnetic core having four parallel legs in a line or a pair of parallel side by side four leg magnetic cores wherein each core includes four parallel legs in a line. In the single core device, two adjacent legs are utilized as control legs which have respective windings that are serially connected. In the dual core device, first and second pairs of side-by-side legs are utilized as control legs which have respective windings that are serially connected. A consideration with the four leg devices problems related to the fact that one of the control legs is closer to the primary leg that the other control leg, which results in unbalanced leakage flux in the control legs. Moreover, the shape of the four leg devices provides an impediment to compact implementation.

### SUMMARY OF THE INVENTION

It would therefore be an advantage to provide a non-saturating magnetic amplifier that is compactly implemented and has a simple equivalent circuit.

The foregoing and other advantages are provided by the invention in a magnetic amplifier that includes a magnetic core having a primary leg, a secondary leg, and first and second control legs each spaced at substantially the same distance from the primary leg. A primary winding is disposed about the primary leg, a secondary winding is disposed about the secondary leg, and first and second serially connected windings are respectively disposed about the first and second control legs. The main flux induced by the primary winding divides into (a) coupling flux that travels to the second leg and induces a voltage in the second winding which provides the output of the device, and (b) leakage flux that travels to the control legs. The allocation or division of the AC main flux as between the secondary leg and the control legs is controlled by a DC control flux that is induced in the control legs by a DC control current in the control windings.

### BRIEF DESCRIPTION OF THE DRAWINGS

The advantages and features of the disclosed invention will readily be appreciated by persons skilled in the art from the following detailed description when read in conjunction with the drawing wherein:

FIG. 1 a schematic perspective illustration of a non-saturating magnetic amplifier in accordance with the invention.

FIG. 2 is a schematic elevational view of the magnetic amplifier of FIG. 1.

FIG. 3 is a schematic sectional plan view of the magnetic amplifier of FIG. 1.

FIG. 4 is a schematic diagram of an equivalent circuit for the magnetic amplifier of FIG. 1.

### DETAILED DESCRIPTION OF THE DISCLOSURE

In the following detailed description and in the several figures of the drawing, like elements are identified with like reference numerals.

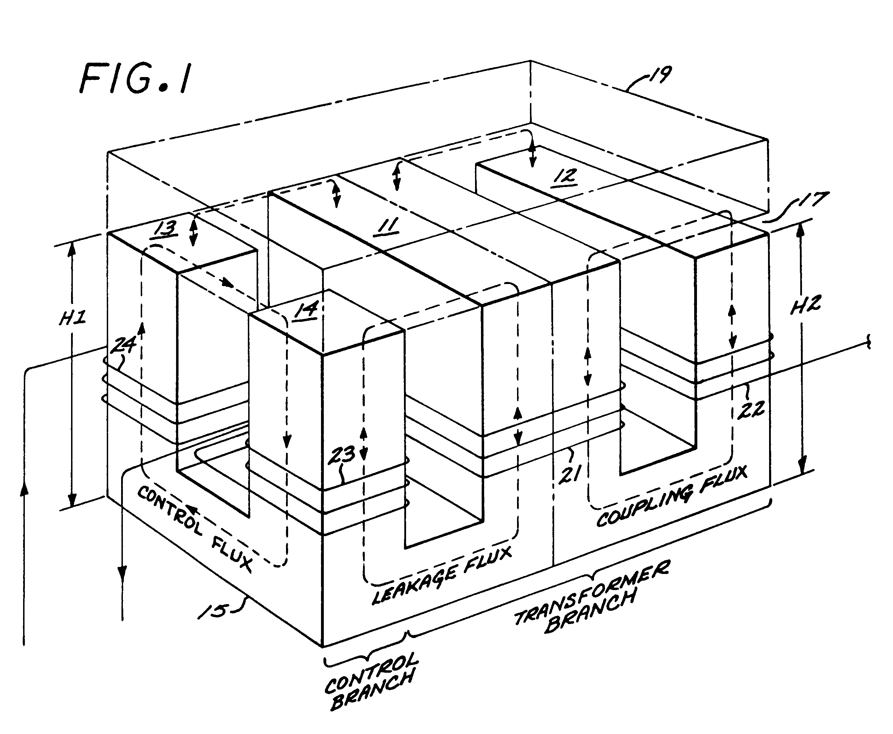

Referring now to FIGS. 1-3, schematically illustrated therein is a non-saturating magnetic amplifier in accordance with the invention which includes a ferromagnetic core having a rectangular base plate 15 and a first leg 11 extending orthogonally from the center of the base plate 15 and spanning the width of the base plate 15. The ferromagnetic core further includes a second leg 12 that extends orthogonally from one end of the base plate 15 parallel to the first leg 11 and spans the width of the base plate 15. Third and fourth substantially identical legs 13, 14 extend orthogonally from the other end of the base plate 11 parallel to the first leg, and are perpendicular to the length of the device. The third and fourth legs 13, 14 have the same cross sectional area as measured parallel to the base plate 15, and are equidistant from the centrally located first leg 11. In other words, the distance between the third leg 13 and the first leg, as measured along the longitudinal extent of the base plate, is substantially equal to the distance between the fourth leg 14 and the first leg 11, as measured along the longitudinal extent of the base plate.

The first, third, and fourth legs 11, 13, 14 have substantially the same height H1, and the second leg 12 has a height H2 which is less that H1. A top plate 19, shown in partial section to allow viewing of the legs of the core, is substantially coextensive with the base plate 15 and disposed on the ends of the first, third, and fourth legs 11, while being separated from the end of the second leg 12 by an air gap 17.

The cross sectional areas of the respective legs, as measured parallel to the base and top plates, will depend upon the amount of main flux that will be diverted to the primary leg by a particular application. As a starting point, the cross sectional area of the first leg should be about equal to sum of the cross sectional areas of the second, third, and fourth legs, wherein the cross sectional areas of the third and fourth legs are substantially equal.

A primary winding 21 is wound around the first leg 11 which for convenience will also be referred to as the primary leg, while a secondary winding 22 is wound around the second leg 12 which for convenience will also be referred to as the secondary leg. Serially connected control windings 23, 24 are respectively counter-wound (i.e., in opposite directions) an equal number of turns around the third and fourth legs 13, 14 which for convenience will also be referred to as the control legs.

The primary winding 21 generates an AC main flux, schematically shown in FIG. 1, which divides into (a) coupling flux that travels to the secondary leg 12 and (b) leakage flux that travels to the control legs 13, 14. The coupling flux in the secondary leg 12 induces a voltage in the secondary winding 22 which provides the output of the device.

The allocation or division of the AC main flux is controlled by a DC control flux that is induced the control legs 13, 14 by a DC control current in the serially connected, counter-wound control windings. As shown in FIG. 1, the DC control flux circulates in the closed structure comprising the control legs 13, 14 and the ends of the base plate and the top plate 19 that underlie and overlie the control legs and the region therebetween. Since the core comprises ferromagnetic material, the permeability of the material is dependent on the flux density therein. When the control current is zero, almost all of the main flux travels in the control legs since the path that includes the primary leg and the control legs has a lower reluctance than the path that includes the primary leg, the secondary leg, and the air gap, which results from the air gap; and the output voltage on the secondary winding will be zero. As the DC control voltage is increased, the reluctance in the control legs increases, which increases the amount of main flux diverted toward the secondary leg, and the voltage on the secondary winding increases.

The magnetic amplifier basically includes (a) a control branch comprised of the control legs 13, 14 and the ends of the base plate 15 and the top plate 19 that underlie and overlie the control legs and the region therebetween, and (b) a transformer section comprised of the remaining portion of the magnetic amplifier. The magnetic amplifier is operated without driving the transformer section into saturation, which provides for a proportional relation between the DC control current applied to the control windings and the AC output voltage across the secondary winding 22.

The magnetic amplifier of FIG. 1 provides important advantages over the three leg and four leg magnetic amplifier structures of U.S. Patent 4,821,428. As compared to the four leg in-line structures of U.S. Patent 4,821,428, the subject magnetic amplifier is more compact and balances the leakage flux in the control legs 13, 14 since the control legs are at the same distance from the primary leg 11 (i.e., the leakage flux is split equally between the control legs). In the four leg in-line structures of U.S. Patent 4,821,428, balancing the leakage flux between the control legs is difficult since one control leg is much closer to the primary leg. Such imbalance of leakage flux tends to induce undesirable coupling between the primary winding and the control windings. The balanced flux in the magnetic amplifier of the invention reduces the voltage on the control winding that is due to imperfect cancellation of the induced voltages on the control windings around the control legs. The balanced flux ensures that the loss in the core material is evenly distributed through the core which reduces heat buildup.

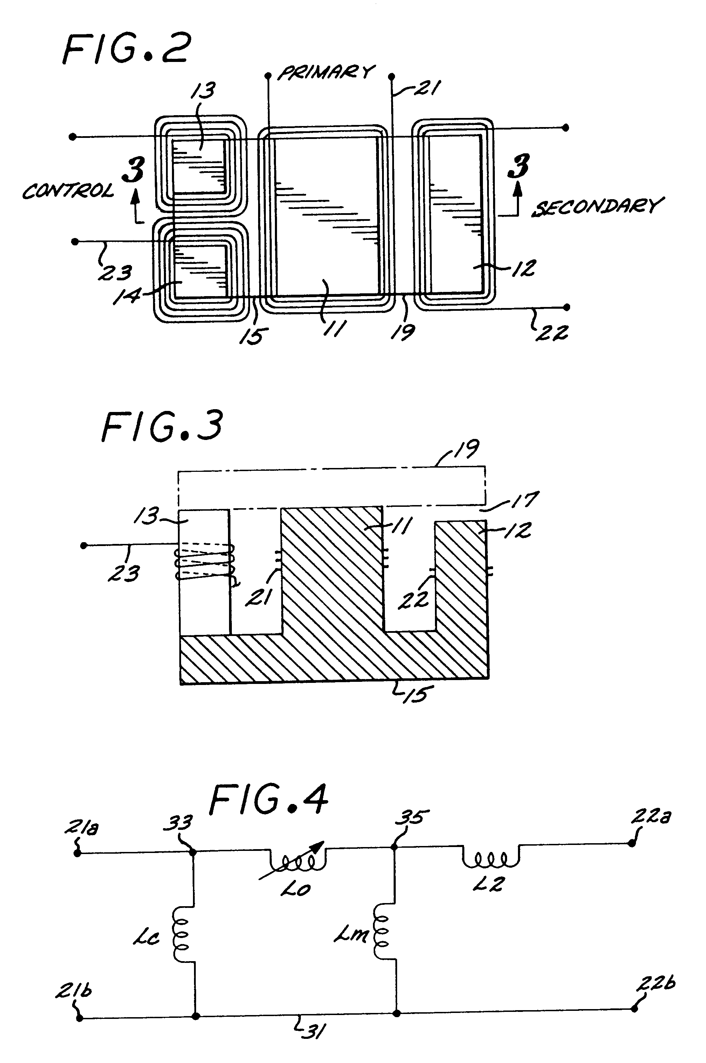

As compared to the three leg structure of U.S. Patent 4,821,428, the magnetic amplifier of the subject invention effectively includes only one inductive element that varies with control current, while the three leg structure of U.S. Patent 4,821,428 effectively includes two inductive elements that vary with control current. This can be better appreciated by reference to FIG. 4 which sets forth therein is an equivalent circuit that models the behavior of the magnetic amplifier of the invention. The equivalent circuit includes an inductance L_{c} connected between a node 31 and a node 33 represents the inductance associated with the primary leg, while an inductance Lₒ connected between the node 33 and a node 35 represents the inductance of the leakage flux path. Further, an inductance Lₘ connected between the node 35 and the node 31 represents the inductance associated with the coupling flux and has a value that is controlled by the air gap, and an inductance L₂ connected between the node 35 and a terminal 22a represents the parasitic leakage inductance of the secondary winding. The terminal 22a and a terminal 22b connected to the node 31 are the secondary winding connections; and terminals 21a, 21b connected to the nodes 33, 31 are the primary winding connections. The connections to the control windings are not included since the effect of the control windings is to alter the reluctance of the control legs of the core, and the inductances in the equivalent circuit are inversely proportional to reluctance. Thus, the effect of varying reluctance is achieved by varying inductance, as set forth in the equivalent circuit.

The inductances L_{c} and Lₒ are dependent on the permeability of the core while the Lₘ and L₂ are dependent on the permeability of air. This implies in general that the inductances L_{c} and Lₒ will vary with control current. In the magnetic amplifier of FIG. 1, only the inductance Lₒ varies as a function of the control current since the control flux is confined to the control legs 13, 14. In the three leg structure of U.S. Patent 4,821,428, the inductance Lₒ varies as a function of control current, and the inductance L_{c} also varies as a function of control current since the leakage flux and the control flux are intermingled in the primary leg as a result of the central gap between the side by side core elements. Since the magnetic amplifier in accordance with the invention effectively includes only one inductance that varies with control current, design of external components utilized therewith is significantly simplified. Effectively, a magnetic amplifier in accordance with the invention includes structure that confines the control flux to the control leg structure, whereby control flux does not flow in the primary or secondary legs and the control of the magnetic amplifier is significantly simplified.

Although the foregoing has been a description and illustration of specific embodiments of the invention, various modifications and changes thereto can be made by persons skilled in the art without departing from the scope and spirit of the invention as defined by the following claims.

## Claims

1. A magnetic amplifier comprising:
a magnetic core having a primary leg, a secondary leg, and first and second control legs each spaced at substantially the same distance from the primary leg;
a primary winding disposed about said primary leg;
a secondary winding disposed about said secondary leg; and
first and second serially connected control windings respectively disposed about said first and second control legs;
whereby leakage flux is equally split between the first and second control legs and whereby the amount of leakage flux in the first and second control legs is controlled by control flux induced in the control legs by current in the serially connected control windings.

2. The magnetic amplifier of Claim 1 wherein said first and second control legs are identical, and wherein said first and second control legs have respective cross sectional areas that are substantially equal.

3. The magnetic amplifier of Claim 1 wherein said secondary leg is on one side of the primary leg and said first and second control legs are on a side that is opposite said one side.

4. A magnetic amplifier comprising:
a magnetic core having a primary leg, a secondary leg, and first and second control legs;
a primary winding disposed about said primary leg;
a secondary winding disposed about said secondary leg; and
first and second serially connected control windings respectively disposed about said first and second control legs for inducing a control flux in said first and second control legs;
said first and second control legs being configured to prevent control flux from flowing in said primary and secondary legs.

5. The magnetic amplifier of Claim 4 wherein said first and second control legs are substantially identical, and wherein said first and second control legs have respective cross sectional areas that are substantially equal.

6. The magnetic amplifier of Claim 4 wherein said secondary leg is on one side of the primary leg and said first and second control legs are on a side that is opposite said one side.
